# EUROPEAN PATENT APPLICATION

(11) **EP 4 756 459 A1**
(43) Date of publication of application: **10.06.2026**
(21) Application number: 24863144.2
(22) Date of filing: 02.09.2024
(51) Int. Cl.: G01R 31/396, G01R 31/367, G01R 31/36, H01M 10/48, G06F 17/10, G06F 17/40, G06N 20/00

(54) **BATTERY MANAGEMENT DEVICE AND BATTERY MANAGEMENT METHOD**

(30) Priority: 04.09.2023 KR 20230116958
(71) Applicant: LG Energy Solution, Ltd., Seoul 07335 (KR)
(72) Inventor: CHUN, Joo Young, Daejeon 34122 (KR)
(74) Representative: Plasseraud IP
(86) International application number: PCT/KR2024/013183
(87) International publication number: WO 2025/053563

(57) **Abstract**

A battery management apparatus disclosed herein includes a sensor unit configured to obtain battery data of a plurality of battery cells, a memory configured to store a reference parameter for determining whether the battery data is normal, and a controller configured to generate pre-processed data by pre-processing the battery data, generate converted data by converting the pre-processed data based on a Gramian angular field (GAF) algorithm, and determine abnormal battery data from the battery data based on the converted data and the reference parameter.

## Description

### TECHNICAL FIELD

### CROSS-REFERENCE TO RELATED APPLICATION

This application claims priority to and the benefit of Korean Patent Application No. 10-2023-0116958 filed in the Korean Intellectual Property Office on September 4, 2023, the entire content of which is incorporated herein by reference.

### TECHNICAL FIELD

Embodiments disclosed herein relate to a battery management apparatus and a battery management method.

### BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium-ion battery is attracting attention as a next-generation energy storage medium as a usage range thereof is expanded to a power source of electric vehicles.

As the occurrence of defective battery cells, such as tab disconnection or lithium precipitation, in the battery may cause safety issues during battery use, research is being conducted on a defective battery cell detection algorithm. Conventionally, in order to detect defective battery cells, battery data obtained from a plurality of battery cells need to be plotted and individually labeled for manual determination, requiring excessive time and cost.

### DISCLOSURE

### TECHNICAL PROBLEM

According to an embodiment disclosed herein, provided are a battery management apparatus and a battery management method based on data plotting to quantitatively detect an abnormal signal among battery management signals.

Technical problems of the embodiments disclosed herein are not limited to the above-described technical problems, and other unmentioned technical problems would be clearly understood by one of ordinary skill in the art from the following description.

### TECHNICAL SOLUTION

A battery management apparatus according to an embodiment includes a sensor unit configured to obtain battery data of a plurality of battery cells, a memory configured to store a reference parameter for determining whether the battery data is abnormal, and a controller configured to generate pre-processed data by pre-processing the battery data, generate converted data by converting the pre-processed data based on a Gramian angular field (GAF) algorithm, and determine abnormal battery data from the battery data based on the converted data and the reference parameter.

The controller may be further configured to generate a battery data frame based on the pre-processed data.

The controller may be further configured to generate and plot the converted data as an image.

The controller may be further configured to align the converted data based on a Pearson correlation coefficient.

The controller may be further configured to quantify a similarity by comparing the aligned converted data with normal data and determine, as abnormal battery data, battery data having the similarity being less than or equal to a reference value set based on the reference parameter.

The controller may be further configured to generate the pre-processed data such that the battery data has specific intervals based on interpolation.

The controller may be further configured to generate the pre-processed data by smoothing the battery data based on a data smoothing scheme.

A battery management method according to an embodiment disclosed herein includes obtaining battery data of a plurality of battery cells, generating pre-processed data by pre-processing the battery data, generating converted data obtained by plotting the pre-processed data based on a Gramian angular field (GAF) algorithm, and determining abnormal battery data among the battery data based on the converted data and a reference parameter for determining whether the battery data is abnormal.

The battery management method according to an embodiment may further include generating a battery data frame based on the pre-processed data.

The battery management method according to an embodiment may further include generating and plotting the converted data as an image.

The battery management method according to an embodiment may further include aligning the converted data based on a Pearson correlation coefficient.

The determining of the abnormal battery data may include quantifying a similarity by comparing the aligned converted data with normal data and determine, as abnormal battery data, battery data having the similarity being less than or equal to a reference value set based on the reference parameter.

The generating of the pre-processed data may include generating the pre-processed data such that the battery data has specific intervals based on interpolation.

The generating of the pre-processed data may include generating the pre-processed data by smoothing the battery data based on a data smoothing scheme.

### ADVANTAGEOUS EFFECTS

The battery management apparatus according to an embodiment may detect abnormal battery data based on a pattern of plotted battery data, thereby reducing time and cost for detecting the abnormal battery data.

The battery management apparatus according to an embodiment may transmit abnormal battery data to an external device through a communication unit, thereby enabling convenient battery diagnosis.

The battery management apparatus according to an embodiment may diagnose the battery data in parallel, thereby allowing use of the battery data for machine learning.

### DESCRIPTION OF DRAWINGS

FIG. 1 is a block diagram showing a configuration of a general battery system including a battery management apparatus according to an embodiment.
FIG. 2 is a block diagram showing a configuration of a battery management apparatus according to an embodiment.
FIG. 3 schematically shows a flow for a controller of a battery management apparatus to determine whether battery data is abnormal, according to an embodiment.
FIG. 4 shows a pattern of battery data plotted by a battery management apparatus according to an embodiment.
FIG. 5 shows different patterns of battery data plotted by a battery management apparatus according to an embodiment.
FIG. 6 shows a reference value for detecting abnormal battery data by a battery management apparatus according to an embodiment.
FIG. 7 shows abnormal battery data and normal battery data together, classified by a battery management apparatus according to an embodiment.
FIG. 8 is a flowchart of a battery management method according to an embodiment.
FIG. 9 is a flowchart continuously showing the battery management method of FIG. 8.

### MODE FOR INVENTION

Hereinafter, various embodiments disclosed herein will be described in detail with reference to the accompanying drawings. In this document, identical reference numerals will be used for identical components in the drawings, and the identical components will not be redundantly described.

For various embodiments disclosed herein, specific structural or functional descriptions are only exemplified for the purpose of describing the embodiments, and various embodiments disclosed herein may be implemented in various forms, and should not be construed as being limited to the embodiments described herein.

As used in various embodiments, the terms "1^{st}, "2^{nd}", "first", "second", or the like may modify various components regardless of importance, and do not limit the components. For example, a first component may be named as a second component without departing from the right scope of an embodiment disclosed herein, and similarly, the second component may be named as the first component.

Terms used herein are used for only describing a specific exemplary embodiment and may not have an intention to limit the scope of other exemplary embodiments. It is to be understood that the singular forms include plural references unless the context clearly dictates otherwise.

All terms including technical or scientific terms used herein have the same meaning as commonly understood by those of ordinary skill in the art to which the embodiments disclosed herein belong. It will be further understood that terms, such as those defined in commonly used dictionaries, should be interpreted as having a meaning that is identical to or similar with their meaning in the context of the relevant art and will not be interpreted in an idealized or overly formal sense unless expressly so defined herein. In some cases, the terms defined herein may be interpreted to exclude embodiments disclosed herein.

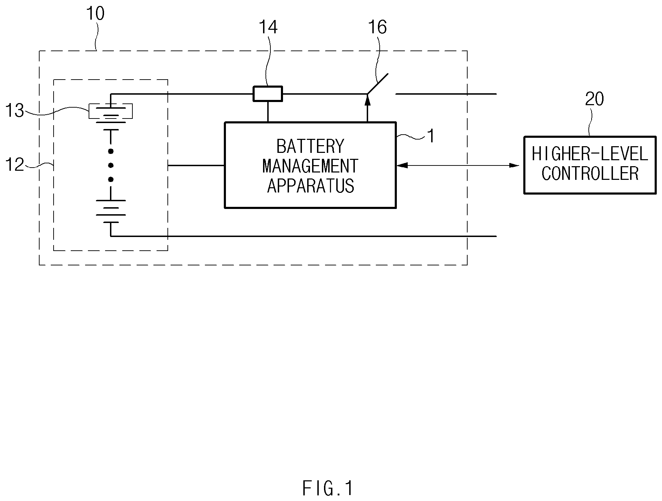

FIG. 1 is a block diagram showing a configuration of a general battery system including a battery management apparatus according to various embodiments.

Specifically, FIG. 1 schematically shows a battery system 10 and a higher-level controller 20 included in a higher-level system according to an embodiment disclosed herein.

As shown in FIG. 1, the battery system 10 may include a plurality of battery modules 12, a sensor unit 14, a switching unit 16, and a battery management apparatus 1. The battery system 10 may include the battery module 12, the sensor unit 14, the switching unit 16, and the battery management apparatus 1 provided in plural.

The plurality of battery modules 12 may include at least one chargeable/dischargeable battery cells 13. The battery cell 13 may include a cathode, a cathode material, an anode, an anode material, a separator, polymer, and a case. In this case, the plurality of battery modules 12 may be connected in series or in parallel.

The sensor unit 14 may include a voltage sensor 2, a current sensor 3, and a temperature sensor 4 (not shown).

The voltage sensor 2 may be connected in parallel with the battery and configured to detect a battery voltage across opposite ends of the battery and generate a voltage signal indicating the detected battery voltage.

The current sensor 3 may detect a current to be applied to a current integration method in a process of determining an SOH of the battery cell 13.

The current sensor 3 may include any component for generating a signal corresponding to a magnitude of a charging current, and may be installed on a charging/discharging path in which the charging/discharging current flows in a battery.

The current sensor 3 may measure a battery current flowing in the battery, i.e., a charging current and a discharging current, and transmit a measurement result to the battery management apparatus 1. According to an embodiment, the current sensor 3 may measure the battery current at predetermined intervals and transmit a measurement result to the battery management apparatus 1, in a charging cycle for charging the battery with power of an external device or a discharging cycle for discharging the battery.

The temperature sensor 4 may be configured to measure a battery temperature and generate a temperature signal indicating the measured battery temperature. The temperature sensor 4 may be disposed in a case to measure a temperature close to an actual temperature of the battery. For example, the temperature sensor 4 may be attached to a surface of at least one battery cell included in a cell group and detect the surface temperature of the battery cell as the battery temperature.

The temperature sensor 4 may be configured to measure an external temperature that is a temperature at a predetermined position spaced apart from the battery and generate the temperature signal indicating the measured external temperature. The temperature sensor 4 may be arranged at a predetermined position outside the case in which heat exchange is made between the battery and the atmosphere. According to an embodiment, the temperature sensor 4 may be implemented in combination of one or two or more of known temperature detection elements such as a thermocouple, a thermistor, a bimetal, etc. The temperature sensor 4 may detect current flowing in the battery system 10. In this case, a detection signal may be transmitted to the battery management apparatus 1.

While the sensor unit 14 is connected between a positive electrode of the battery cell 13 and the switching unit 16 in FIG. 1, a connection relationship between components shown in FIG. 1 may be an example and is not limited thereto.

The switching unit 16 may be serially connected to a positive (+) terminal side or a negative (-) terminal side of the battery module 12 to control a charging/discharging current flow of the battery module 12. For example, for the switching unit 16, at least one relay, a magnetic contactor, etc., may be used, depending on the specification of the battery system 10.

The battery management apparatus 1 may perform control and management to prevent over-charging and over-discharging by monitoring voltage, current, temperature, etc., of the battery system 10, and may include, for example, a BMS.

The battery management apparatus 1, which is an interface for receiving measurement values of the above-described various parameter values, may include a plurality of terminals and a circuit, etc., connected thereto to process input values. Further, the battery management apparatus 1 may control on/off of the switching unit 16, for example, a relay, a contactor, etc., and may be connected to the battery module 12 to monitor a state of each battery module 12.

The battery management apparatus 1 may receive voltage data, current data, and temperature data from the sensor unit 14 to obtain battery state information and diagnose a state of the battery.

The higher-level controller 20 may transmit a control signal for controlling the battery module 12 to the battery management apparatus 1. Thus, the battery management apparatus 1 may be controlled in terms of an operation thereof based on the control signal applied from the higher-level controller 20. Also, the battery module 12 may be a component included in an energy storage system (ESS). In this case, the higher-level controller 20 may be a control unit (BBMS) of a battery bank including the plurality of battery systems 10 or an ESS control unit for controlling the entire ESS including a plurality of banks. However, the battery system 10 is not limited to such a purpose.

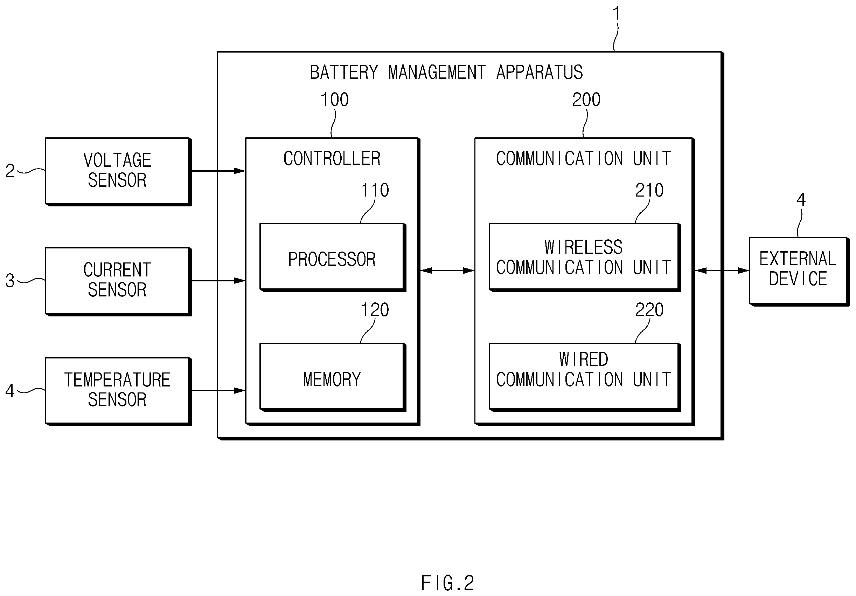

FIG. 2 is a block diagram showing a configuration of a battery management apparatus according to an embodiment.

Referring to FIG. 2, the battery management apparatus 1 according to an embodiment may include a controller 100 including at least one processor 110 and a memory 120 and a communication unit 200, and may diagnose a battery by communicating with an external device 5 through the communication unit 200.

According to an embodiment, the external device 5 communicating with the battery management apparatus 1 may include a user terminal that transmits a diagnosis result of the battery management apparatus 1.

Specifically, when the external device 5 is a user terminal, the controller 100 of the battery management apparatus 1 may transmit a diagnosis result of the battery to the user terminal to enable a user to check the diagnosis result. In this case, the user terminal may include, but not limited to, a personal computer (PC), a terminal, a portable telephone, a smart phone, a handheld device, a wearable device, etc.

The battery management apparatus 1 according to an embodiment may mean any electronic device including the processor 110 and the memory 120, and may be mounted on a vehicle to operate. Hereinbelow, each component of the battery management apparatus 1 may be described in detail.

The communication unit 200 may include a wireless communication unit 210 and a wired communication unit 220 to communicate with the external device 5. The communication unit 200 may transmit and receive a program for feature calculation, class classification, and lifespan estimation for a battery cell or various data, etc., to and from a separately provided external server.

The wireless communication unit 210 may include at least one of a short-range communication module or a long-range communication module.

The short-range communication module may communicate with the external device 5 adjacent to the battery management apparatus 1 by using a short-range communication method. Herein, the short-range communication module may use one communication method among Bluetooth, Bluetooth low energy (BLE), infrared data association (IrDA), Zigbee, WiFi, WiFi Direct, ultra-wideband (UWB), or near field communication (NFC).

The long-range communication module may include a communication module performing various types of long-range communication, and may include a mobile communication module. The mobile communication unit may transmit and receive a radio signal to and from at least one of a base station, an external terminal, or the external device 5 over a mobile communication network. The long-range communication module may communicate with the external device 5 or other electronic devices, etc., through a nearby access point (AP). The AP may connect a local area network (LAN) to which the battery management apparatus 1 is connected to a wide area network (WAN) to which the communication server is connected. Thus, the battery management apparatus 1 may be connected to the communication server through the external device 5 and the WAN to communicate with each other.

The wired communication unit 220 may access the wired communication network and communicate with the external device 5 through the wired communication network. For example, the wired communication unit 220 may access the wired communication network through Ethernet (IEEE 802.3, technical standards), access the wired communication network through CAN communication, and transmit and receive data to and from the external devices 5 through the wired communication network.

The battery management apparatus 1 according to an embodiment may include an input/output interface (not shown). An interface may be provided to allow data to be transmitted and received by connecting an input device (not shown) such as a keyboard, a mouse, a touch panel, etc., an output device such as a display (not shown), etc., and the processor 110.

The memory 120 may store various information required for driving of the battery management apparatus 1. Specifically, the memory 120 may store an operating system and a program required for driving of the battery management apparatus 1 or store data required for driving of the battery management apparatus 1.

Specifically, the memory 120 may store various programs regarding feature calculation, class classification, and lifespan estimation of the battery cell. Moreover, the memory 120 may store various data such as a voltage, a current, a temperature, feature data, etc., of each battery cell.

The memory 120 may store pre-processed data pre-processed by the processor 110 and store converted data generated by the processor 110. The memory 120 may store a reference parameter for determining whether battery data is abnormal.

The memory 120 may include a volatile memory 120 such as a static random access memory (S-RAM) and a dynamic random access memory (D-RAM) to temporarily memorize data. The memory 120 may also include a non-volatile memory 120 such as a read only memory (ROM), an erasable programmable read only memory (EPROM), and an electrically erasable programmable read only memory (EEPROM), to store data for a long time.

The processor 110 may control in overall the battery management apparatus 1 by outputting a control signal. The processor 110 may include one CPU or graphics processing unit (GPU) or a plurality of CPUs or GPUs. In this case, the processor 110 may be implemented as an array of multiple logic gates, or may be implemented as a combination of the general-purpose microprocessor 110 and the memory 120 storing a program executable on the microprocessor 110.

The memory 120 and the processor 110 may be included in the controller 100 that controls the above-described components to determine abnormal battery data among the battery data.

Specifically, the controller 100 may generate pre-processed data by pre-processing the battery data and generate converted data obtained by converting the pre-processed data based on a Gramian angular field (GAF) algorithm. The controller 100 may determine the abnormal battery data among the battery data based on the converted data and a reference parameter.

The controller 100 may generate a battery data frame based on the pre-processed data, and generate the converted data as an image for plotting.

The controller 100 may arrange the converted data based on a Pearson correlation coefficient and compare the arranged converted data with normal data to quantify a similarity and determine, as abnormal battery data, battery data having a similarity less than or equal to a reference value set based on the reference parameter.

The controller 100 may generate the pre-processed data such that the battery data has a specific interval based on interpolation, and smooth the battery data based on a data smoothing method to generate the pre-processed data.

Thus, the battery management apparatus 1 according to an embodiment may detect the abnormal battery data generated when a battery cell 13 is defective, based on data plotting, thereby achieving a significant effect of improving the efficiency of defect diagnosis.

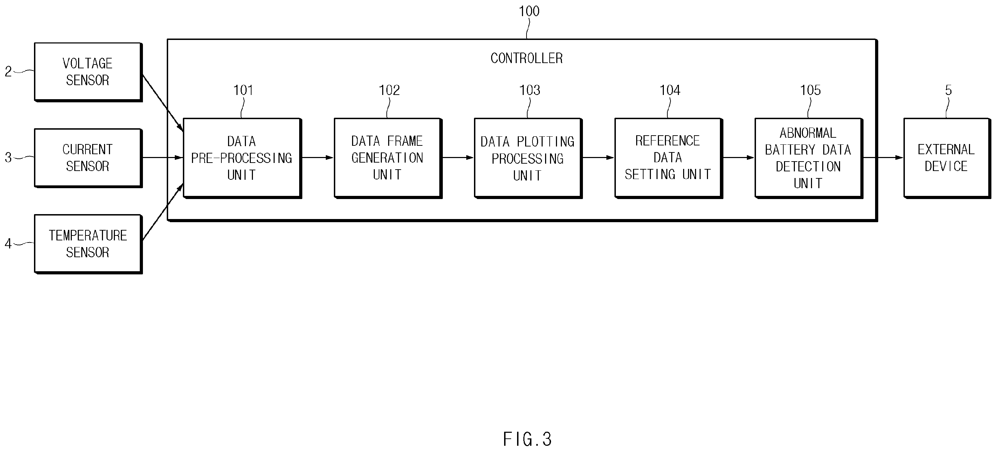

FIG. 3 schematically shows a flow for the controller 100 of the battery management apparatus 1 to determine whether battery data is abnormal, according to an embodiment.

Referring to FIG. 3, the controller 100 of the battery management apparatus 1 according to an embodiment may include battery data including a voltage value, a current value, and a temperature value at specific points in time from the voltage sensor 2, the current sensor 3, and the temperature sensor 4.

Thereafter, a data pre-processor of the controller 100 may process the battery data received from the sensor unit 14 into a form easy to plot. Herein, data pre-processing refers to a process of processing data in a form appropriate for analysis and processing, and generally, the battery data may have an empty or inconsistent data part depending on a field in which the battery is used, such that data pre-processing refers to a process of unifying the same.

According to an embodiment, as an example of data pre-processing performed in the battery management apparatus 1, the controller 100 may generate pre-processed data such that the battery data has specific intervals based on interpolation.

Herein, interpolation may refer to a scheme to form a new data point within an isolation point of a known data point, and may include linear interpolation. That is, the controller 100 may pre-process the battery data to enable quantitative analysis of the battery data by matching different sampling periods of battery data for different battery cells 13 based on interpolation.

According to an embodiment, as another example of data pre-processing performed in the battery management apparatus 1, battery data may be smoothed based on data smoothing to generate pre-processed data.

Herein, data smoothing may refer to a data pre-processing scheme to reduce a random variance generated in time-series data collected over time, and may include a scheme based on a moving average filter and a scheme based on a Kalman filter.

Specifically, the moving average filter may refers to a scheme to sequentially smooth data by obtaining an average of n adjacent data in consecutive data, and may smooth data by alleviating a sharp change in consecutive data when the consecutive data changes rapidly.

The Kalman filter may refer to smoothing data by modeling a time-series process with a combination of data volatility and a measurement error, and may be applied to a case where a state of data at a specific point in time has a linear relationship with a state of the data at a previous point in time.

As such, the battery management apparatus 1 according to an embodiment may minimize an influence of noise by pre-processing the battery data to detect abnormal battery data.

Next, a data frame generation unit of the controller 100 may generate a data frame based on pre-processed battery data. Herein, the data frame may mean a data structure in which data is stored in the form of a two-dimensional (2D) table having rows and columns. The data frame may facilitate a comparison or arithmetic operation by unifying data formats.

A data plotting processing unit of the controller 100 may plot the pre-processed data based on a GAF algorithm. The controller 100 may generate converted data obtained by converting the pre-processed data into a specific pattern image based on the GAF algorithm.

The GAF algorithm may express time-series data as an image of a non-cartesian coordinates system and may use a polar coordinate system instead of a cartesian coordinate system. The GAF algorithm uses the polar coordinate system and thus may express a temporal correlation of each point, and a time increases from a top left end toward a bottom right end of the plotted pattern image, thereby preserving time dependency.

A reference data setting unit of the controller 100 may set a reference value by setting a parameter to detect abnormal battery data. Specifically, the controller 100 may receive a parameter from a user, obtain the parameter based on a machine learning scheme, and set the reference value based on the parameter. The reference value may refer to a maximum similarity based on a similarity quantified by comparing representative normal data with data of a comparison group, and the representative normal data may refer to data to represent the entire group among data regarding a voltage, a current, and a temperature, as data obtained by experiment.

An abnormal data detection unit of the controller 100 may align data based on a Pearson correlation coefficient, and the controller 100 may detect, as abnormal data, battery data having a similarity less than or equal to a specific value based on the set maximum similarity. Thus, the battery data may also be expanded to three or more classifications in addition to normal and abnormal detection.

Thereafter, the controller 100 may transmit the detected abnormal data to the external device 5 to inform the user of detection of the abnormal data.

The controller 100 may then transmit a diagnosis result to the external device 5 when diagnosing that the abnormal data occurs. The diagnosis result may include a signal indicating that the battery cell 13 is abnormal or normal and a diagnosis message indicating that the battery cell 13 is abnormal or normal.

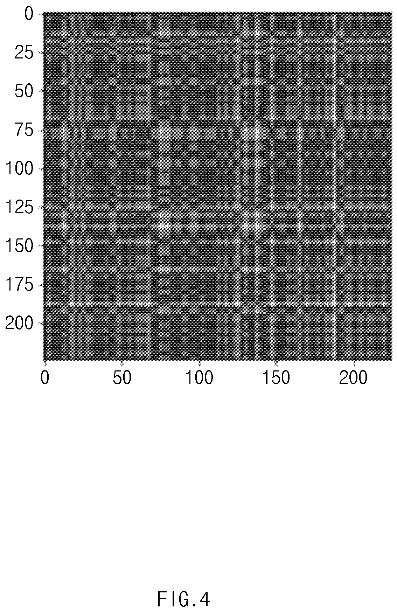

FIG. 4 shows a pattern of battery data plotted by the battery management apparatus 1 according to an embodiment.

Referring to FIG. 4, the controller 100 may receive the battery data from the sensor unit 14, pre-process and plot the battery data, as described above. The controller 100 may plot the battery data based on the GAF algorithm, and FIG. 4 shows an example of a pattern image plotted based on the GAF algorithm.

The plotted pattern image may have x-axis and y-axis values corresponding to data characteristics and may be expressed as a pixel in the form of a square as shown in FIG. 4. The GAF algorithm may include a Gramian angular summation field (GASF) and a Gramian angular difference field (GADF) according to the form of a triangular function used.

The plotted pattern image in FIG. 4 may include a bright part and a dark part, which may be a result, performed by the controller 100, of imaging each part according to the characteristics of the battery data.

Thus, when a plurality of battery data include only data in a normal state, plotted pattern image data may show similar patterns, and when the plurality of battery data include data in an abnormal state, the plotted pattern image data may include dissimilar and unique patterns.

That is, based on the foregoing characteristics, the battery management apparatus 1 according to an embodiment may detect that the plotted pattern image data has dissimilar and unique patterns when the plurality of battery data include data in the abnormal state.

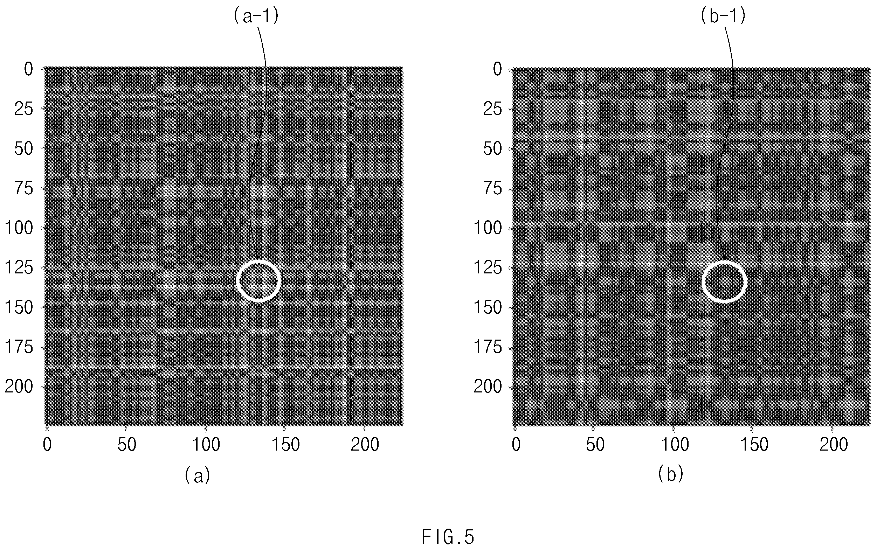

FIG. 5 shows different patterns of battery data plotted by the battery management apparatus 1 according to an embodiment.

Referring to FIG. 5, the controller 100 may generate two or more plotted pattern images based on the GAF algorithm. That is, the controller 100 may plot a plurality of pre-processed battery data to compare similarities of plotted patterns of battery data.

Referring to (a) and (b) of FIG. 5 together, two plotted pattern images generated by the controller 100 may show different patterns. Specifically, a bright part is expressed as four square pixels in (a-1), but the bright part is expressed as one square pixel in (b-1).

In this way, the controller 100 of the battery management apparatus 1 according to an embodiment may compare similarities of two different patterns and quantify them.

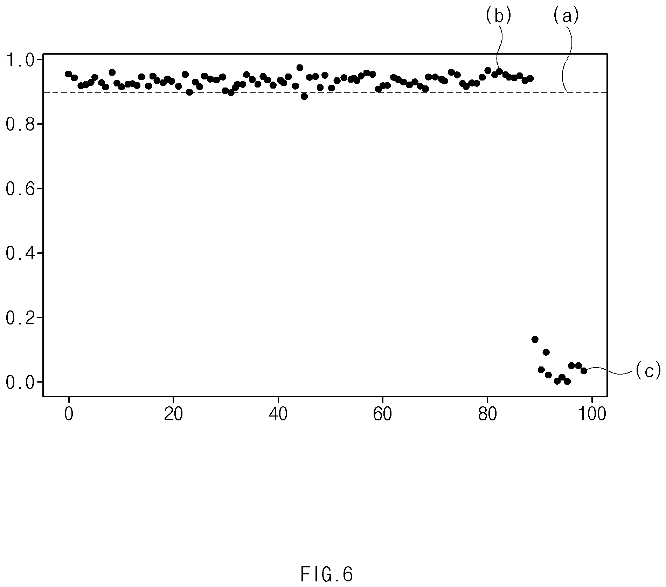

Thereafter, the controller 100 may determine whether a specific pattern image is normal data or abnormal data based on a reference value for a similarity, as shown in FIG. 6.

FIG. 6 shows a reference value for detecting abnormal battery data by the battery management apparatus 1 according to an embodiment.

Referring to FIG. 6, the controller 100 may determine a reference value a for detecting abnormal battery data based on a reference parameter stored in the memory 120 or determine the reference value a based on a machine learning scheme.

The reference value a determined by the controller 100 may a maximum value for a similarity, preset by a manager or derived based on the machine learning scheme.

The controller 100 may determine, as normal battery data b, battery data having a similarity with representative normal data, which exceeds the reference value a, and determine, as abnormal battery data c, battery data having the similarity with the representative normal data, which is less than or equal to the reference value a.

With the battery management apparatus 1 according to an embodiment, a lot of battery data may be compared in parallel and abnormality of the battery data may be determined, thereby improving the efficiency of battery diagnosis.

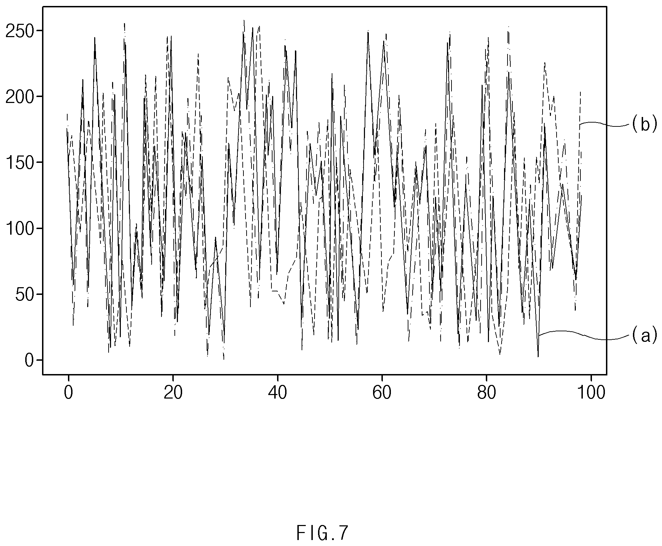

FIG. 7 shows abnormal battery data and normal battery data together, classified by the battery management apparatus 1 according to an embodiment.

(a) of FIG. 7 shows a battery characteristic graph based on normal battery data, and (b) of FIG. 7 shows a battery characteristic graph based on normal battery data. In FIG. 7, the graph (a) and the graph (b) may not be easily distinguished using a general graph interpretation method.

However, with the battery management apparatus 1 according to an embodiment, battery data corresponding to the graph (a) and battery data corresponding to the graph (b) may be plotted and the plotted pattern images may be compared to determine similarities of two battery data, thereby facilitating distinguishment between the graph (a) and the graph (b).

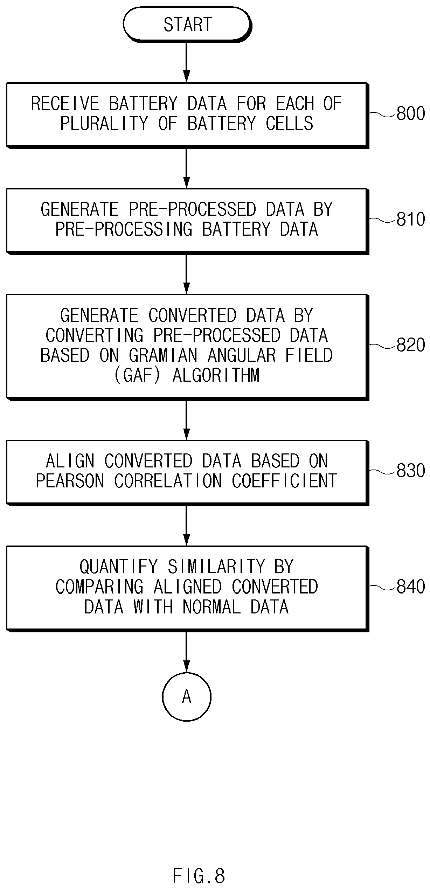

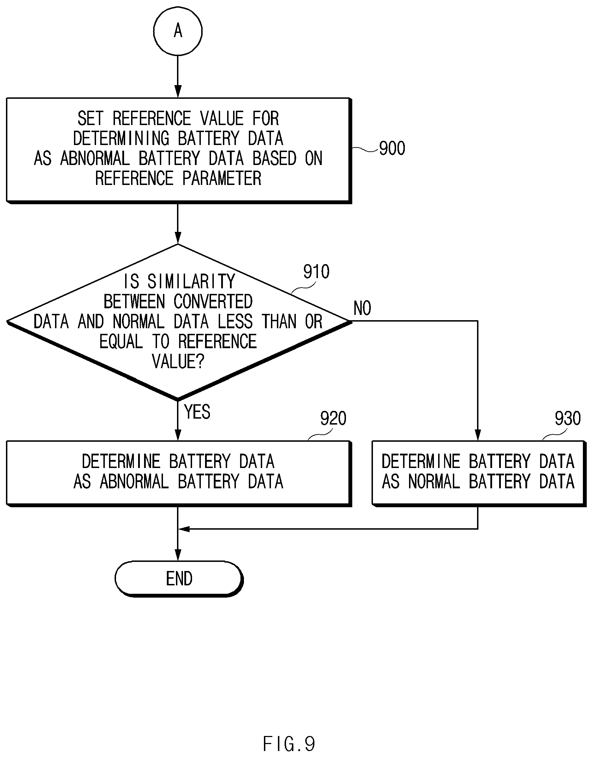

FIG. 8 is a flowchart of a battery management method according to an embodiment, and FIG. 9 is a flowchart continuously showing the battery management method of FIG. 8.

Referring to FIG. 8, the controller 100 may receive battery data for each of the plurality of battery cells 13 from the sensor unit 14, in operation 800.

In operation 810, the controller 100 may pre-process the battery data to generate pre-processed data. The controller 100 may generate the pre-processed data such that the battery data has a specific interval based on interpolation, or smooth the battery data based on a data smoothing method to generate the pre-processed data.

In operation 820, the controller 100 may generate converted data obtained by plotting the pre-processed data based on the GAF algorithm.

The controller 100 may align the converted data based on a Pearson correlation coefficient in operation 830, and compare the aligned converted data with the normal data to quantify a similarity in operation 840. The similarity may refer to a result of quantification by comparing image patterns with the representative normal data.

Referring to FIG. 9, in operation 900, the controller 100 may set a reference value for determining battery data as abnormal battery data based on the reference parameter. The reference value may mean a threshold value for distinguishing battery data of a pattern having a high similarity with the representative normal data from battery data having a low similarity with the representative normal data.

The controller 100 may determine whether a similarity between the converted data plotted based on the GAF algorithm and normal data is less than or equal to the reference value, in operation 910.

When the controller 100 determines that the similarity between the converted data and the normal data exceeds the reference value in operation 910 (No), the controller 100 may determine the battery data as normal battery data in operation 930. When the controller 100 determines that the similarity between the converted data and the normal data is less than or equal to the reference value in operation 910 (Yes), the controller 100 may determine the battery data as abnormal battery data in operation 920.

As such, the battery management apparatus 1 according to an embodiment may plot various battery data collected in a field such as an electric vehicle or an ESS to perform abnormal data detection based on a similarity, thereby efficiently and accurately performing diagnosis.

Meanwhile, disclosed embodiments may be implemented in the form of a recording medium that stores an instruction executable by a computer. The instruction may be stored in the form of a program code, and, when executed by a processor, may generate a program module and perform operations according to disclosed embodiments. The recording medium may be implemented as a computer-readable recording medium.

The computer-readable recording medium may include any type of recording media that store an instruction interpretable by a computer. For example, the computer-readable recording medium may include read-only memory (ROM), random-access memory (RAM), a magnetic tape, a magnetic disk, flash memory, an optical data storage device, etc.

In addition, the computer-readable recording medium may be provided in the form of a non-transitory storage medium. Herein, the term 'non-transitory storage medium' simply means that the storage medium is a tangible device, and does not include a signal (e.g., an electromagnetic wave), but this term does not differentiate between where data is semi-permanently stored in the storage medium and where the data is temporarily stored in the storage medium. For example, the 'non-transitory storage medium' may include a buffer storing data temporarily.

According to an embodiment of the disclosure, a method according to various embodiments of the disclosure may be included and provided in a computer program product. The computer program product may be traded as a product between a seller and a buyer. The computer program product may be distributed in the form of a machine-readable recording medium (e.g., compact disc read only memory (CD-ROM)), or be distributed (e.g., downloaded or uploaded) online via an application store (e.g., Play Store^{™}), or between two user devices (e.g., smart phones) directly. When distributed online, at least a part of the computer program product (e.g., a downloadable app) may be temporarily generated or at least temporarily stored in the machine-readable recording medium, such as memory of the manufacturer's server, a server of the application store, or the memory 102 of a relay server.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

## Claims

1. A battery management apparatus comprising:
a sensor unit configured to obtain battery data of a plurality of battery cells;
a memory configured to store a reference parameter for determining whether the battery data is normal; and
a controller configured to generate pre-processed data by pre-processing the battery data, generate converted data by converting the pre-processed data based on a Gramian angular field (GAF) algorithm, and determine abnormal battery data from the battery data based on the converted data and the reference parameter.

2. The battery management apparatus of claim 1, wherein the controller is further configured to generate a battery data frame based on the pre-processed data.

3. The battery management apparatus of claim 2, wherein the controller is further configured to generate and plot the converted data as an image.

4. The battery management apparatus of claim 3, wherein the controller is further configured to align the converted data based on a Pearson correlation coefficient.

5. The battery management apparatus of claim 4, wherein the controller is further configured to quantify a similarity by comparing the aligned converted data with normal data and determine, as abnormal battery data, battery data having the similarity being less than or equal to a reference value set based on the reference parameter.

6. The battery management apparatus of claim 1, wherein the controller is further configured to generate the pre-processed data such that the battery data has specific intervals based on interpolation.

7. The battery management apparatus of claim 1, wherein the controller is further configured to generate the pre-processed data by smoothing the battery data based on a data smoothing scheme.

8. A control method of a battery management apparatus, the control method comprising:
obtaining battery data of a plurality of battery cells;
generating pre-processed data by pre-processing the battery data;
generating converted data by converting the pre-processed data based on a Gramian angular field (GAF) algorithm; and
determining abnormal battery data from the battery data based on the converted data and a reference parameter for determining whether the battery data is abnormal.

9. The control method of claim 8, further comprising generating a battery data frame based on the pre-processed data.

10. The control method of claim 9, further comprising generating and plotting the converted data as an image.

11. The control method of claim 10, further comprising aligning the converted data based on a Pearson correlation coefficient.

12. The control method of claim 11, wherein the determining of the abnormal battery data comprises quantifying a similarity by comparing the aligned converted data with normal data and determine, as abnormal battery data, battery data having the similarity being less than or equal to a reference value set based on the reference parameter.

13. The control method of claim 8, wherein the generating of the pre-processed data comprises generating the pre-processed data such that the battery data has specific intervals based on interpolation.

14. The control method of claim 8, wherein the generating of the pre-processed data comprises generating the pre-processed data by smoothing the battery data based on a data smoothing scheme.
